(19) Europäisches Patentamt

European Patent Office

Office européen des brevets

(11) **EP 1 732 316 A1**

(12) **EUROPEAN PATENT APPLICATION**

(43) Date of publication:
**13.12.2006 Bulletin 2006/50**

(51) Int Cl.:
*H04N 5/44* (2006.01)    *H03D 7/16* (2006.01)

(21) Application number: **05018404.3**

(22) Date of filing: **24.08.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **06.06.2005 US 160031**

(71) Applicant: **Quantek, Inc.**
**Sindian City**
**Taipei Hsien (TW)**

(72) Inventors:
• **Tseng, Chao-Wen**
**Baoshan Hsiang**
**Hsin-Chu Hsien (TW)**
• **Lau, Wai**
**Hsindian City**
**Taipei Hsien (TW)**

(74) Representative: **Schaeberle, Steffen**
**Hoefer & Partner,**
**Patentanwälte,**
**Gabriel-Max-Strasse 29**
**81545 München (DE)**

(54) **Single-conversion integrated circuit tv tuner**

(57)    A single-conversion integrated circuit TV tuner (100, 300) includes a first filter (103, 302) coupled to an RF signal input (RF), and a harmonic rejection mixer (105, 305) connected to a real output of the first filter (103, 302). The harmonic rejection mixer (105, 305) has complex output. The TV tuner (100, 300) further includes a polyphase filter (106, 306) having complex input connected to the complex output of the harmonic rejection mixer (105, 305). Only a real signal is passed from the first filter (103, 302) to the harmonic rejection mixer (105, 305).

Fig. 1

**Description**

The present invention relates to a single (direct) conversion integrated circuit TV tuner according to the pre-characterizing clause of claim 1.

Broadband tuners are used in a variety of consumer and commercial systems such as TVs, VCRs, and more sophisticated devices that include cable modems and cable set-top-boxes.

Serving as the RF front-end of broadband signals, the tuner is responsible for receiving all available channels, selecting the desired channel and filtering out the others. These tuners typically operate over a frequency range from 40 to 900 MHz and so have different performance requirements from traditional TV tuners. In these tuners, frequency conversion architecture is essential to tuner design.

World Intellectual Property Organization publication WO 02/093732, which is included herein by reference, describes a state-of-the art integrated TV tuner. This type of TV tuner uses double conversion, and thus includes two polyphase filters and two mixers.

Another example of an integrated TV tuner is one that has been developed by PHILLIPS. The TDA8275 silicon IC tuner provides a low intermediate frequency (IF) signal to a subsequent decoder device, but relies on proprietary architecture to do so. That is, commonly available decoders or demodulators cannot be used with the TDA8275.

This in mind, the present invention aims at providing a single-conversion integrated circuit TV tuner that can be used with off-the-shelf decoders or demodulators and that allows for all active components to be on a single silicon chip.

This is achieved by a single-conversion integrated circuit TV tuner according to claim 1. The dependent claims pertain to corresponding further developments and improvements.

As will be seen more clearly from the detailed description following below, the claimed single-conversion integrated circuit includes a harmonic rejection mixer having a real input connected to a real output of a first filter, wherein only a real signal is passed from the first filter to the harmonic rejection mixer.

In the following, the invention is further illustrated by way of example, taking reference to the accompanying drawings. Thereof

Fig.1 is a block diagram of a TV tuner circuit according to a first embodiment of the invention,
Fig.2 is a block diagram of the selectable band-pass filter of Fig.1,
Fig.3 is a block diagram of a TV tuner circuit according to a second embodiment of the invention,
Fig.4 is a block diagram of the digitally-controlled tracking filter of Fig.3, and
Fig.5 is a block diagram of an application of a TV tuner according to the invention.

The invention is described in the context of a terrestrial TV tuner, however, the invention also applies to other TV tuner applications, such as cable TV, set-top-boxes, and digital TV. Moreover, the invention can also be applied in systems that use signaling similar to that of TV. The invention offers an on-chip solution for single or direct frequency conversion. The invention directly down-converts TV signals of typical frequencies to a programmable intermediate frequency (IF) signal compatible with most commonly available demodulators or decoders.

First Embodiment

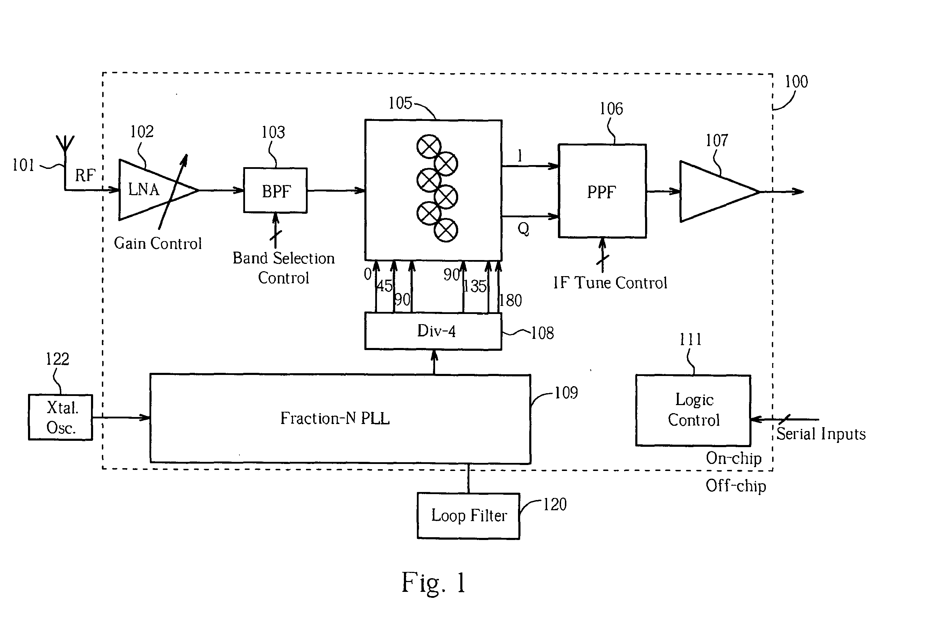

Fig.1 shows a block diagram of a TV tuner circuit 100 according to a first embodiment of the invention. The TV tuner circuit 100 is coupled to an external antenna 101 at an RF signal input. The circuit 100 comprises a low-noise variable-gain amplifier 102 connected to a selectable band-pass filter 103. The selectable band-pass filter 103 is connected to a harmonic rejection mixer 105 having complex output. Hereinafter, the term "complex" is used to refer to any connection or signal that has in-phase (I) and quadrature-phase (Q) parts. Following the harmonic rejection mixer 105 comes an IF polyphase filter 106 which is connected to a subsequent surface acoustic wave (SAW) driver 107. The TV tuner circuit 100 further comprises a frequency divider (e.g. divide by 4) 108 with six phases of output connected to the mixer 105, and a fractional-n phase-locked loop (FNPLL) 109, which is connected to an external loop filter 120 and a reference frequency from a crystal oscillator 122. Logic control 111 is provided on chip to control select functions of the TV tuner circuit 100 according to serial input. The components 102-109 of the TV tuner circuit 100 are disposed on the same silicon chip, while the external antenna 101 and loop filter 120 are not.

The antenna 101 supplies a wideband RF TV signal to the amplifier 102. Then, subsequent to the band-pass filter 103, the narrowband signal reaches the mixer 105. At the mixer 105, the relatively narrow band real RF signal is mixed with LO signals (0, 45, 90 degrees) output by the frequency divider 108 to create the I-IF signal and with signals (90, 135, 180 degrees) output by the frequency divider 108 to create the Q-IF signal. The LO signals have a resolution of about 1/8 phase (i.e. 45 degrees) to synthesize a composite LO I/Q signal. The mixed signals output from the mixer 105 are combined in the IF polyphase filter 106 and then forwarded to the SAW driver 107 to be made available to off-chip devices such as an IF SAW filter.

The low-noise variable-gain amplifier 102 should be capable of handling wideband signals common in TV applications. It should have enough dynamic range to adjust to different levels of input signal, such as those found in standard TV signals. Moreover, the amplifier 102 should provide wideband matching while maintaining a substantially constant output level with relatively constant noise.

The integrated selectable band-pass filter 103 limits a number of channels that load the mixer 105. Thus, band-pass filter 103 relaxes the linearity requirement for the remainder of the signal chain (105-107). In addition, the band-pass filter 103 attenuates undesired signals in image frequencies due to harmonics of the LO frequencies. The RF inputs can be separated into several sections and then selected by a band selection control signal upon request. The gain and corner frequencies for integrated selectable band-pass filter 103 are programmed by either the users or internal calibration circuits. This offers another advantage over the prior art.

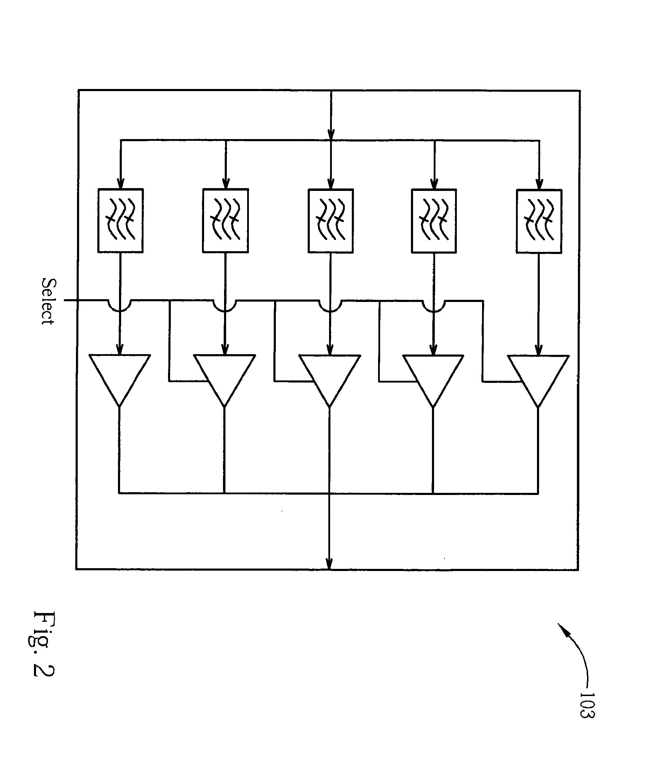

Fig.2 illustrates an embodiment of the band-pass filter 103. The RF input to the band-pass filter 103 is separated into five components that can be selected by way of a "select" input. The selectable components are predetermined frequency ranges that depend on the specific application. Equally, the RF input to the band-pass filter 103 can also be separated into three components, such as high frequency (HF), band-pass frequency (BPF), and low frequency (LF), or any other number of components. These types of band-pass filters are examples, and other, well-known band-pass filters can also be used in the TV tuner circuit 100.

The band-pass filter 103 can be implemented with inductances and/or capacitances, which can be on- or off-chip depending on the specific requirements.

The harmonic rejection mixer 105 comprises double quadrature mixers with three phases for I and three phases for Q, which reject 3rd and 5th order LO harmonics. The mixer 105 receives RF inputs and LO inputs. The mixer 105 can be switched to a conventional double-quadrature mixer when the 3rd LO harmonic is beyond the input spectrum. Such switching is done by using only a single phase LO for either the I or Q LO signals. In the preferred embodiment, the harmonic rejection mixer 105 is directly connected to the integrated selectable band-pass filter 103 and receives only real (in-phase, I) signals at this input. This direct connection and lack of an intervening polyphase filter is another advantage of the invention over the prior art.

The IF polyphase filter 106 suppresses negative frequencies in the IF signal output by the harmonic rejection mixer 105. An IF tune control input can be used to control the IF polyphase filter 106. The IF polyphase filter 106 can have a center frequency of around 30-60 MHz to correspond with commonly available SAW filters for US TV applications. Other applications may require other center frequencies.

The SAW driver 107 should be selected to linearly drive the specific external SAW filter, and should have a frequency such as 44 MHz for US standard linearity. For versatility in application, the SAW driver 107 should be compatible with off-the-shelf SAW filters.

The FNPLL 109 comprises a frequency synthesizer with fractional selection, which synthesizes LO frequencies for channel selection for the signal chain (102-107). A voltage-controlled oscillator (VCO) of the FNPLL 109 can include an integrated spiral inductor and varactors. With integrated spiral inductors, VCO can eliminate off-chip inductors and package bond wire inductors. Hence, any variations related to those inductors are reduced. In addition, programming the FNPLL 109 allows selection (according to design requirements) of high or low IF at the output of the SAW driver 107, which is an improvement over prior art devices, specifically those with on-chip SAW filters, that can only output low IF. Other, commonly-known kinds of PLLs or inductors (i.e. non-spiral) are also acceptable for use in the TV tuner circuit 100.

This first embodiment achieves a higher level of integration over the prior art. The single (direct) conversion high-IF architecture has substantially reduced complexity and production cost. In addition, the choice of high-IF architecture reduces the sizes of on-chip components (i.e. resistors and capacitors) thus reducing die size. Moreover, the choice of low-IF architecture is also possible. Furthermore, this embodiment is compatible with commercially available demodulators (decoders) and off-chip SAW filters. Regarding overall performance, it is desirable to use an off-chip IF SAW filter for band selection due to its excellent filtering nature. In terms of cost and performance, the present invention single conversion to high IF architecture is a good compromise.

Second Embodiment

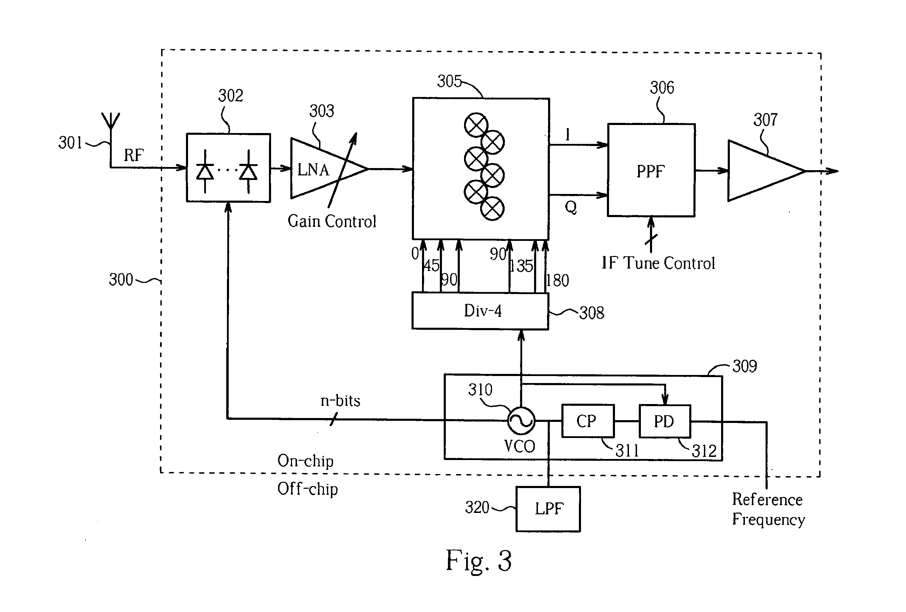

Please refer to Fig.3, which shows a block diagram of a fully-integrated TV tuner circuit 300 according to a second embodiment of the invention. The TV tuner circuit 300 employs a front-end digitally control tracking filter using on-chip varactors or similar.

The TV tuner circuit 300 is coupled to an external antenna 301 at an RF signal input. The circuit 300 comprises a digitally-controlled tracking filter 302 connected to a low-noise variable-gain amplifier 303. The amplifier 303 is connected to a harmonic rejection mixer 305 having complex output. Similar to the first embodiment, following the harmonic rejection mixer 305 comes an IF polyphase filter 306 which is connected to a subsequent SAW driver 307. The TV tuner circuit 300 further comprises a frequency divider (e.g. divide by 4) 308 with six phases of output connected to the mixer 305, and a PLL 309, which is connected to an external low-pass filter 320 and a reference frequency. The PLL 309 includes a VCO 310, a charge pump (CP) 311, and a phase detector (PD) 312. The PLL 309 is also connected to the tracking filter 302 to allow a control signal of the PLL 309 to be provided to the tracking filter 302. The components 302-312 of the TV tuner circuit 300 are disposed on the same silicon chip, while the external antenna 301 and low-pass filter 320 are not.

The antenna 301 supplies a wideband RF TV signal to the digitally-controlled tracking filter 302, the signal then passes through the low-noise variable-gain amplifier 303. Then, the narrowband signal reaches the mixer 305. At the mixer 305, the relatively narrow band real RF signal is mixed with LO signals (0, 45, 90 degrees) output by the frequency divider 308 to create the I-IF signal and with signals (90, 135, 180 degrees) output by the frequency divider 308 to create the Q-IF signal. The LO signals have a resolution of about 1/8 phase (i.e. 45 degrees) to synthesize a composite LO I/Q signal. As in the first embodiment, the mixed signals output from the mixer 305 are combined in the IF polyphase filter 306 and then forwarded to the SAW driver 307 to be made available to off-chip devices such as an IF SAW filter.

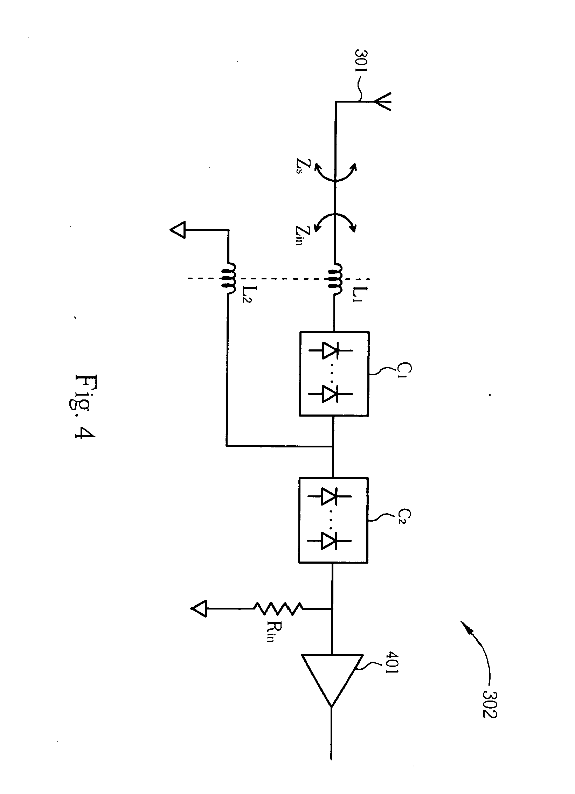

The digitally-controlled tracking filter 302 is located at the front of this architecture, and provides early channel selection. The tracking filter 302 accepts the digital control code which is derived from the VCO 310 varactor bank digital code. Hence, the input power to the following low noise amplifier 303 is decreased. As a consequence, in the entire signal chain 302-307, the linearity requirement and power consumption are greatly reduced. If the tracking filter 302 is sharp enough, then it is not necessary to use the mixer 305, and this can be replaced by a suitable image rejection mixer. Fig.4 illustrates detail of an embodiment of the digitally-controlled tracking filter 302.

Fig.4 illustrates an embodiment of the digitally-controlled tracking filter 302. The tracking filter 302 includes two digitally-tuned variable capacitances C1, C2, which can be realized by varactors, varicaps, or like devices. An inductance L1 exists between the capacitance C1 and the antenna 301. An inductance L2 exists between the two capacitances C1, C2 and off-chip ground. The inductances L1, L2 can be either chip bonding wires, or a combination of bonding wires and off-chip inductors. The tracking filter 302 further comprises an amplifier 401 provided at the output of the variable capacitances C1, C2. (Note: in the following equations and in Fig. 4, like variables are the same regardless of subscript, i.e. Zin = $Z_{in}$)

Referring to Fig.4, supposing the tuned frequency is $\omega_{CH} = \dfrac{1}{\sqrt{L1C1}} = \dfrac{1}{\sqrt{L2C2}}$ when tuned at the matched condition, i.e. when a source impedance Zs is about equal to an input impedance Zin. Thus,

$$Zin = j\omega_{CH}L1 + \frac{1}{j\omega_{CH}C1} + \left( j\omega_{CH}L2 // \frac{1}{j\omega_{CH}C2} // Rin \right)$$

when (L1, C1) and (L2, C2) are set resulting in the tuned frequency and assuming an input resistance of Rin (as shown in Fig.4). Thus,

$$Zin = \frac{-\omega_{CH}^2 L1C1 + 1}{j\omega_{CH}C1} + \frac{\dfrac{L2Rin}{C2}}{\dfrac{L2}{C2} + Rin\left( \dfrac{-\omega_{CH}^2 L2C2 + 1}{j\omega_{CH}C2} \right)} \; .$$

Since

$$-\omega_{CH}^2 L1C1 = -\omega_{CH}^2 L2C2 = -1 \quad ,$$

then

$$Zin = Rin.$$

Thus, if the input resistance Rin is set equivalent to the source impendence Zs, then the input network can match the tuned frequency.

Referring back to Fig.3, the low-noise variable-gain amplifier 303 should be capable of handling input signals with low noise contribution and low power consumption. It should have enough dynamic range to adjust to different levels of input signal, such as those of standard terrestrial TV signals.

As in the first embodiment, the harmonic rejection mixer 305 comprises double quadrature mixers with three phases for I and three phases for Q, which reject 3rd and 5th order LO harmonics. The mixer 305 receives RF inputs and LO inputs. The mixer 305 is preferably selected for low-side mixing, and can be switched to a conventional double-quadrature mixer when the 3rd LO harmonic is beyond the input spectrum. Such switching is done by using only a single phase LO for either the I or Q LO signals.

The PLL 309 provides frequency synthesis with fractional selection, which provides channel selection for the signal chain. The VCO 310 of the PLL 309 can include an integrated spiral inductor and varactors. The digital control signal (n-bits) of the VCO 310 is applied to the front-end tracking filter 302. As mentioned, the frequency divider 308 divides the output of the PLL by four, so the PLL 309 runs at about four times the LO frequency. In addition, other, commonly-known kinds of PLLs or inductors (i.e. non-spiral) are also acceptable for use in the TV tuner circuit 300.

This second embodiment achieves a higher level of integration over the prior art. By integrating an on-chip digitally controlled tracking filter into a single high-IF conversion architecture, the linearity requirement for the rest of the signal chain as well as its power consumption are substantially reduced. Furthermore, this embodiment is compatible with commercially available demodulators (decoders) and off-chip SAW filters.

General Considerations

The first and second embodiments use similar components, and thus have similar advantages. In addition, many of the specific components of one embodiment can be used in the other embodiment. Specifically, the first embodiment can have the tracking filter 302 in place of the selectable band-pass filter 103, just as the second embodiment can have the selectable band-pass filter 103 in place of the tracking filter 302. Also, the placement in the respective signal chains of the amplifier 102 and the selectable band-pass filter 103, and the tracking filter 302 and the variable-gain amplifier 303 can be reversed. Naturally, the FNPLL 109 and PLL 309 can be used in either embodiment depending on the requirements.

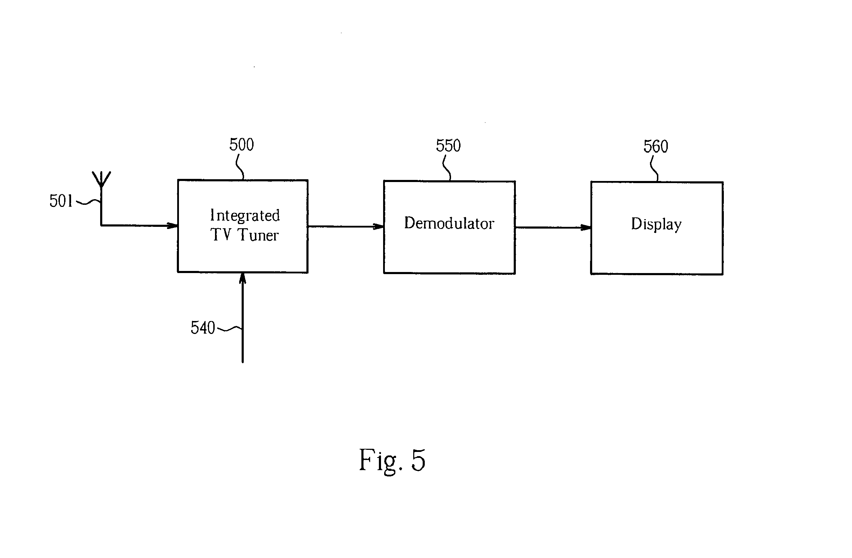

Fig.5 illustrates an application of a TV tuner 500 according to the invention. The TV tuner 500 could be the TV tuner 100 or 300. An antenna 501 feeds the TV tuner 500 a common TV signal. After single or direct frequency conversion and other processing as described in the above embodiments, the TV tuner 500 outputs an IF signal to a demodulator (or decoder) 550, which then outputs a demodulated (or decoded) signal to display hardware 560. Control of the TV tuner 500 is through a control signal 540 which can comprise a channel selection.

Fig.1-5 are schematic and illustrate the components and connections relevant to the invention. Components not relevant to the invention have been omitted for clarity, and the components shown may generally be connected in ways other than illustrated. In addition, many circuit symbols used are well known, such that a component indicated by a symbol alone serves its well-known function.

**Claims**

1. A single-conversion integrated circuit TV tuner (100, 300) comprising:

   a first filter (103, 302) coupled to an RF signal input (RF);
   a harmonic rejection mixer (105, 305) having a real input and having complex output; and
   a polyphase filter (106, 306) having complex input connected to the complex output of the harmonic rejection mixer (105, 305);

   **characterised by**:

the harmonic rejection mixer (105, 305) having the real input connected to a real output of the first filter (103, 302), wherein only a real signal is passed from the first filter (103, 302) to the harmonic rejection mixer (105, 305).

2. The single-conversion integrated circuit TV tuner (100) of claim 1, **characterised in that** the first filter (103) is a selectable band-pass filter and is directly connected to the harmonic rejection mixer (105).

3. The single-conversion integrated circuit TV tuner (100) of claim 2, further **characterised by** a variable-gain amplifier (102) coupled between the RF signal input (RF) and the selectable band-pass filter (103).

4. The single-conversion integrated circuit TV tuner (300) of claim 1, **characterised in that** the first filter (302) is a digitally-controlled tracking filter.

5. The single-conversion integrated circuit TV tuner (300) of claim 4, further **characterised by** a variable-gain amplifier (303) connected directly to the digitally-controlled tracking filter (302) and directly to the harmonic rejection mixer (305).

6. The single-conversion integrated circuit TV tuner (300) of claim 4 or 5, **characterised in that** the digitally-controlled tracking filter (302) comprises at least two variable capacitances (C1, C2) connected in series.

7. The single-conversion integrated circuit TV tuner (300) of claim 6, **characterised in that** a variable capacitance (C1, C2) comprises a varactor.

8. The single-conversion integrated circuit TV tuner (300) of claim 6 or 7, **characterised in that** the digitally-controlled tracking filter (302) further comprises a first inductance (L1) connected in series between the RF signal input (RF) and both variable capacitances (C1, C2), and a second inductance (L2) connected between the variable capacitances (C1, C2) and a ground input.

9. The single-conversion integrated circuit TV tuner (300) of claim 6, 7, or 8, **characterised in that** the digitally-controlled tracking filter (302) further comprises an amplifier (401) connected in series with and subsequent to the two variable capacitances (C1, C2).

10. The single-conversion integrated circuit TV tuner (100, 300) of claim 1, 2, or 4, further **characterised by** an amplifier (107, 307) coupled between the polyphase filter (106, 306) and a signal output.

11. The single-conversion integrated circuit TV tuner (100, 300) of claim 1, 2, 4, or 10, further **characterised by** a local oscillator circuit coupled to the harmonic rejection mixer (105, 305).

12. The single-conversion integrated circuit TV tuner (100, 300) of claim 11, **characterised in that** the local oscillator circuit comprises a phase-locked loop (109, 309), and a frequency divider (108, 308) coupled between the phase-locked loop (109, 309) and the harmonic rejection mixer (105, 305) and providing five phases of output to the harmonic rejection mixer (105, 305).

13. The single-conversion integrated circuit TV tuner (100, 300) of claim 1, 2, 4, 10, 11, or 12, **characterised in that** the first filter (103, 302), the harmonic rejection mixer (105, 305), and the polyphase filter (106, 306) are disposed on one silicon chip.

Fig. 1

Fig. 2

103

Fig. 3

EP 1 732 316 A1

Fig. 4

500

550

560

501

Integrated
TV Tuner

Demodulator

Display

540

Fig. 5

**European Patent Office**

# EUROPEAN SEARCH REPORT

Application Number

EP 05 01 8404

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,Y | US 2004/125240 A1 (STIKVOORT EDWARD FERDINAND ET AL) 1 July 2004 (2004-07-01) | 1-11,13 | H04N5/44 H03D7/16 |
| A | * abstract * * paragraph [0013] * * paragraph [0031] * * paragraph [0032] * * figures 1-6 * | 12 | |
| Y | BROADCOM: "BCM3419 Product Brief" [Online] 15 October 2004 (2004-10-15), BROADCOM , XP002365814 Retrieved from the Internet: URL:http://www.broadcom.com/collateral/pb/ 3419-PB02-R.pdf> [retrieved on 2006-02-02] | 1-11,13 | |
| A | * the whole document * | 12 | |
| A | JOSE EPIFANIO DA FRANCA, CARLOS AZEREDO-LEME, PUN KONG-PANG PUN: "Circuit Design for Wireless Communications: Improved Techniques for Image Rejection in Wideband Quadrature Receivers" 31 March 2003 (2003-03-31), SPRINGER , XP009061090 ISBN: 1-4020-7415-8 * page 25 - page 32 * * figures 2.15,2.16,2.17 * | 1-13 | |

-/--

TECHNICAL FIELDS SEARCHED (IPC)

H04N
H03D

The present search report has been drawn up for all claims

| Place of search | Date of completion of the search | Examiner |
|---|---|---|
| Munich | 3 February 2006 | Schreib, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 05 01 8404

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CROLS J ET AL: "A SINGLE-CHIP 900 MHZ CMOS RECEIVER FRONT-END WITH A HIGH PERFORMANCE LOW-IF TOPOLOGY" IEEE JOURNAL OF SOLID-STATE CIRCUITS, IEEE SERVICE CENTER, PISCATAWAY, NJ, US, vol. 30, no. 12, December 1995 (1995-12), pages 1483-1492, XP000557254 ISSN: 0018-9200 * abstract * * pages 1486-1489 section III: The LOW-IF Receiver * * figures 7-11 * | 1-13 | |
| A | PHILIPS: "TDA827x Silicon Tuner Family" [Online] June 2003 (2003-06), PHILIPS , NETHERLANDS , XP002365815 Retrieved from the Internet: URL:http://www.semiconductors.philips.com/ acrobat_download/literature/9397/75011533. pdf> [retrieved on 2006-02-02] * the whole document * | 1-13 | |
| A | PHILIPS: "TDA827x cable silicon tuner IC" [Online] April 2002 (2002-04), PHILIPS , NETHERLANDS , XP002365816 Retrieved from the Internet: URL:http://www.semiconductors.philips.com/ acrobat_download/literature/9397/75009417. pdf> [retrieved on 2006-02-02] * the whole document * | 1-13 | |

TECHNICAL FIELDS SEARCHED (IPC)

The present search report has been drawn up for all claims

| Place of search | Date of completion of the search | Examiner |
|---|---|---|
| Munich | 3 February 2006 | Schreib, F |

## ANNEX TO THE EUROPEAN SEARCH REPORT
## ON EUROPEAN PATENT APPLICATION NO.

EP 05 01 8404

03-02-2006

| Patent document cited in search report | Publication date | Patent family member(s) | | Publication date |
|---|---|---|---|---|
| US 2004125240    A1 | 01-07-2004 | CN | 1471757 A | 28-01-2004 |
| | | WO | 02093732 A2 | 21-11-2002 |
| | | JP | 2004533167 T | 28-10-2004 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02093732 A